Europäisches Patentamt

European Patent Office

Office européen des brevets

(11) Veröffentlichungsnummer: **0 218 852**
**A1**

(12) **EUROPÄISCHE PATENTANMELDUNG**

(21) Anmeldenummer: **86111517.8**

(22) Anmeldetag: **20.08.86**

(51) Int. Cl.⁴: **H01L 23/50** , H01L 23/52 , G06F 11/20

(30) Priorität: **13.09.85 DE 3532832**

(43) Veröffentlichungstag der Anmeldung:
**22.04.87 Patentblatt 87/17**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Fuchs, Hans Peter, Dipl.-Phys-**
**Mitterhoferstrasse 19**
**D-8000 München 21(DE)**

(54) **Integrierter Schaltkreis mit NC-Pins und Verfahren zu seinem Betreiben.**

(57) Es wird ein integrierter Schaltkreis mit mindestens einem NC-Pin (NC) vorgestellt, der über eine entsprechende Ansteuerung des NC-Pins (NC) besondere Betriebsarten einer im integrierten Schaltkreis enthaltenen integrierten Schaltung (IS) ermöglicht. Eine in der integrierten Schaltung (IS) enthaltene Vorrichtung ermöglicht, beispielsweise durch Verdampfen, das Zerstören einer elektrischen Verbindung (RI) zwischen NC-Pin (NC) und der integrierten Schaltung (IS).

FIG 2

EP 0 218 852 A1

## Integrierter Schaltkreis mit NC-Pins und Verfahren zu seinem Betreiben.

Die Erfindung betrifft einen integrierten Schaltkreis mit einer integrierten Schaltung und mindestens einem NC-Pin nach dem Oberbegriff des Patentanspruches 1 sowie ein Verfahren zu dessen Betreiben. Unter NC-Pin wird dabei, wie in der Fachwelt üblich, ein Bausteinanschluß verstanden, der bestimmungsgemäß elektrisch nicht mit der innerhalb des Schaltkreises integrierten Schaltung verbunden ist. Solche NC-Pins werden z.B. dann verwendet, wenn eine integrierte Schaltung eine ungerade Anzahl von Schaltungsanschlüssen wie elektrische Eingänge und Ausgänge und Versorgungsspannungsanschlüsse aufweist und wenn das Gehäuse, in das oder auf das die integrierte Schaltung montiert werden soll, um einen integrierten Schaltkreis zu ergeben, eine gerade Anzahl von Bausteinanschlüssen (Pins) aufweist.

Bei der Entwicklung und Fertigung von integrierten Schaltkreisen hat es sich als zweckmäßig erwiesen, zeit-und fallweise die in den Schaltkreisen integrierten Schaltungen auf eine spezielle, nicht dem bestimmungsgemäßen Normalbetrieb entsprechende Art zu betreiben, beispielsweise zum Zwecke der Durchführung von Analysen, der Erreichung von bestimmten kritischen Betriebszuständen der Schaltung, wie sie im Normalbetrieb nicht auftreten, oder auch zu Testzwecken, insbesondere unter dem Aspekt einer angestrebten, durch die spezielle Betriebsart ermöglichte Testzeitverkürzung. Um diese besonderen Betriebsarten zu aktivieren, wird beim bekannten Stande der Technik an einem bestimmten Pin, an dem im Normalbetrieb ein beliebiges Signal mit üblichen "High"-und "Low"-Pegeln liegt, ein Signal eingeprägt mit einem Pegel, der einerseits deutlich über dem üblichen "High"-Pegel liegt und der andererseits noch nicht zur Zerstörung der integrierten Schaltung führt. Nähere Informationen bezüglich dieser Schaltungstechnik sind in den DE-OS 30 30 852 und DE-OS 33 18 564 enthalten.

So vorteilhaft diese Technik auch ist (Einsparen von Anschlußpins), so weist sie doch auch Nachteile auf. Einer der Nachteile besteht darin, daß bei vielen integrierten Schaltkreisen der Abstand zwischen dem üblichen spezifizierten "High"-Pegel und der maximal zulässigen Pegelspannung, bei der die integrierte Schaltung gerade noch nicht zerstört wird, so gering ist, daß man ihn, insbesondere unter Berücksichtigung von notwendigen Toleranzwerten, nicht mehr sinnvoll nutzen kann. Ein anderer Nachteil ist der, daß auch Kunden solchermaßen konzipierte integrierte Schaltkreise in diesen besonderen Betriebsarten betreiben können. Damit steigt jedoch das Risiko der Zerstörung der Schaltkreise an, denn im allgemeinen kennen die Kunden nicht eventuell vorhandene besondere Grenzwertbedingungen und wenden im Umgang mit integrierten Schaltkreisen nicht die besondere Sorgfalt an, wie z.B. der Entwickler des Schaltkreises. Ein weiterer Nachteil besteht darin, daß es dem Entwickler oder Produzenten solcher integrierter Schaltkreise nicht möglich ist, besondere Betriebsweisen dem Kunden und Anwender beispielsweise aus marktpolitischen Gründen vorzuenthalten.

Aufgabe der vorliegenden Erfindung ist es deshalb, einen gattungsgemäßen integrierten Schaltkreis zu schaffen, der es einerseits seinem Entwickler und Hersteller ermöglicht, in der integrierten Schaltung enthaltene Schaltungsteile in einer Art zu betreiben, die nicht dem bestimmungsgemäßen Gebrauch (durch den Kunden) entspricht und der es andererseits ermöglicht, unter Ausführen einfachster Maßnahmen diese Möglichkeit des nicht bestimmungsgemäßen Gebrauches zu unterbinden.

Diese Aufgabe wird bei einem gattungsgemäßen integrierten Schaltkreis durch die kennzeichnenden Merkmale der Patentansprüche 1 und 11 gelöst.

Im folgenden wird die Erfindung anhand der Figuren 1 bis 5 näher erläutert. Es zeigen

Fig. 1 einen integrierten Schaltkreis mit mehreren NC-Pins,

die Figuren 2 bis 4 verschiedene Ausführungsformen der Erfindung

Fig. 5 ein Zeit-Spannungsdiagramm für eine Versorgungsspannung und einen Reset-Impuls.

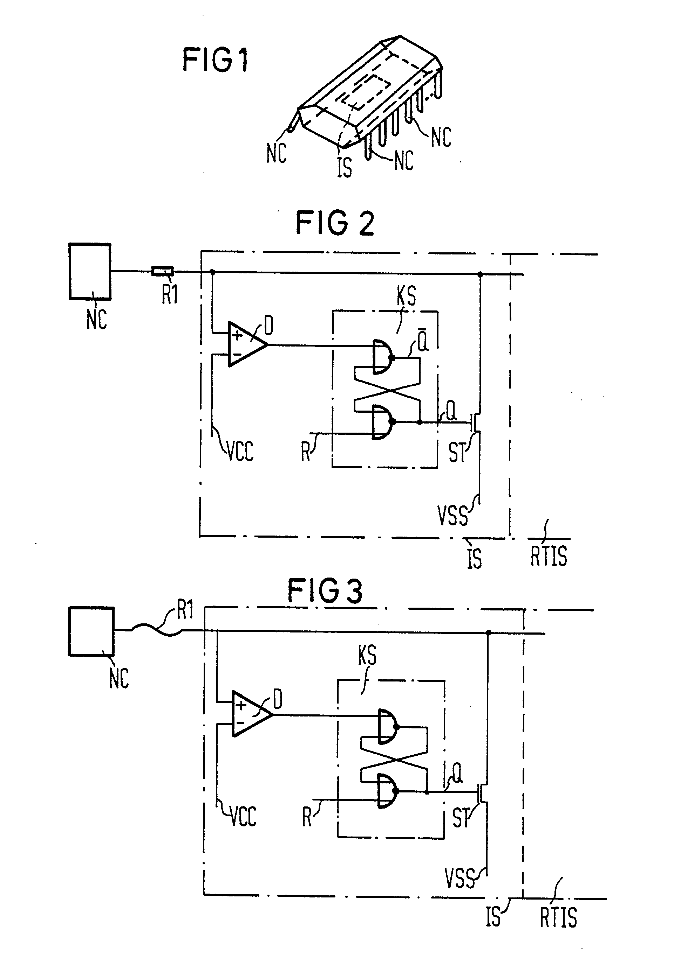

Gemäß Fig. 1 enthält ein erfindungsgemäßer integrierter Schaltkreis eine integrierte Schaltung IS und verschiedene, mit der integrierten Schaltung IS verbundene Bausteinanschlüsse. Er weist außerdem mindestens einen NC-Pin NC auf; in Fig. 1 sind drei NC-Pins NC dargestellt. Die integrierte Schaltung IS enthält Teile, die sich in einer besonderen Art betreiben lassen, die nicht einem, beispielsweise in einem Datenbuch spezifizierten, bestimmungsgemäßen Gebrauch entspricht. Entsprechende besondere Betriebsarten und Verwendungszwecke dieser Betriebsarten sind eingangs beschrieben. Es ist insbesondere auch möglich, daß die integrierte Schaltung ein Halbleiterspeicher ist, der Teile enthält, die es ermöglichen, im Testbetrieb Speicherzellen parallel, d.h. gleichzeitig zu testen, obwohl der Halbleiterspeicher bestimmungsgemäß nicht dazu ausgelegt ist, mehrere Speicherzellen gleich zeitig beschreiben und/oder auslesen zu können.

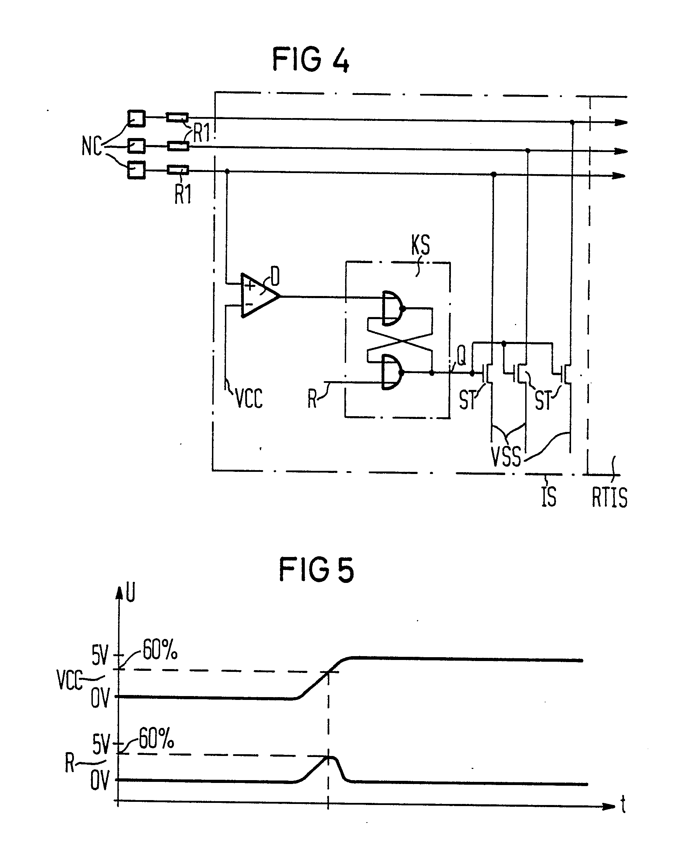

Jeder NC-Pin NC ist gemäß den Figuren 2, 3 und 4 zunächst über eine elektrische Verbindung R1 mit der integrierten Schaltung IS verbunden. Diese elektrische Verbindung R1 kann, wie in den Figuren 2 und 4 dargestellt, ein Widerstand sein. Sie kann jedoch auch eine Leiterbahn sein (vgl. Fig. 3). Beide Ausführungsformen der elektrischen Verbindung R1 sind so dimensioniert, daß bei Überschreiten eines bestimmten maximalen Stromflusses diese (R1) sich selbst zerstören, beispielsweise durch Verdampfen. Als Material für die elektrische Verbindung R1 kann bei beiden Ausführungsformen Polysilizium oder ein Metall, insbesondere Aluminium verwendet werden. Im übrigen wird bezüglich weiterer Ausgestaltungen der elektrischen Verbindung R1 auf die Veröffentlichung "Japanese Journal of Applied Physics", Vol. 22 (1983), Supplement 22-1, Seiten 63 bis 67, betreffend "fusible Links" hingewiesen.

Die integrierte Schaltung IS enthält gemäß den Figuren 2, 3 und 4 des weiteren eine Vorrichtung, die einer Unterbrechung der elektrischen Verbindung R1 zwischen dem NC-Pin NC bzw. den NC-Pins NC und der integrierten Schaltung IS dient. Nach erfolgter Unterbrechung, was beispielsweise durch Verdampfen der elektrischen Verbindung R1 mit Hilfe eines zu großen Stromes geschehen kann, besteht keinerlei elektrische Verbindung mehr zwischen dem NC-Pin NC bzw. den NC-Pins NC und der integrierten Schaltung IS.

Weist ein erfindungsgemäßer integrierter Schaltkreis mehrere NC-Pins NC auf, die der unabhängigen Ansteuerung verschiedener Schaltungsteile der integrierten Schaltung IS im Sinne einer besonderen Betriebsart, wie vorstehend definiert, dienen, so ist es natürlich möglich, entsprechend viele Vorrichtungen zur Unterbrechung der jeweiligen Verbindungen R1 vorzusehen. Es ist jedoch, wie in Fig. 4 gezeigt, und wie nachfolgend noch näher beschrieben werden wird, von besonderem Vorteil, eine einzige solche Vorrichtung für alle obengenannten elektrischen Verbindungen R1 vorzusehen.

Eine Vorrichtung zur Unterbrechung der elektrischen Verbindung R1 weist vorteilhafterweise einen Differenzverstärker D mit einem "+"-Eingang und einem "-"-Eingang auf. Der "+"-Eingang ist mit dem der integrierten Schaltung IS zugewandten Ende der elektrischen Verbindung R1 verbunden. Der "-"-Eingang ist mit einem Spannungspotential hoher Spannung verbunden. Das Spannungspotential kann insbesondere gleich sein einem ersten Versorgungspotential VCC, das beispielsweise 5 V betragen kann, unter den (beispielhaft genannten) Bedingungen, daß die Vorrichtung in n-Kanal-oder CMOS-Technologie realisiert ist.

Der Ausgang des Differenzverstärkers D ist mit einem ersten Eingang einer Kippschaltung KS verbunden. Diese weist noch einen zweiten Eingang auf, der als Reset-Eingang R wirkt. Ein Ausgang Q der Kippschaltung KS ist mit dem Gate eines Schalttransistors ST verbunden, der beispielsweise vom n-Kanal-Typ sein kann. Die Kippschaltung KS kann, wie in den Figuren 2, 3 und 4 gezeigt, zwei NOR-Gatter enthalten, deren Ausgänge einerseits zwei Ausgänge Q und $\overline{Q}$ der Kippschaltung KS mit komplementärem Schaltverhalten bilden und die andererseits über Kreuz zu weiteren (internen) Eingängen der Kippschaltung KS rückgekoppelt sind.

Der Schalttransistor ST ist mit seiner Kanalstrecke zwischen einem zweiten Versorgungspotential VSS und dem der integrierten Schaltung IS zugewandten Ende der elektrischen Verbindung R1 angeordnet. Damit ist er also gleichzeitig auch mit dem "+"-Eingang des Differenzverstärkers D und einem restlichen Teil (RTIS) der integrierten Schaltung IS verbunden. Das Gate des Schalttransistors ST ist mit dem Ausgang Q der Kippschaltung KS verbunden.

Die Schaltung der Vorrichtung zur Unterbrechung der elektrischen Verbindung R1 ist so ausgelegt, daß der Schalttransistor ST immer sperrt, solange am "+"-Eingang des Differenzverstärkers D ein höchstens gleich großes Spannungspotential anliegt wie am "-"-Eingang. Dies ist insbesondere immer dann gewährleistet, wenn am "-"-Eingang des Differenzverstärkers D das erste Versorgungspotential VCC der integrierten Schaltung IS anliegt und am NC-Pin NC ein Signal angelegt wird mit einem Maximalwert, der dem ersten Versorgungspotential VCC entspricht.

Weist der integrierte Schaltkreis mehrere NC-Pins NC auf mit einer elektrischen Verbindung R1, die es ermöglichen, die integrierte Schaltung IS in mehreren voneinander unabhängigen besonderen Betriebsarten zu betreiben, die gegebenenfalls sogar miteinander kombiniert werden können, so ist es selbstverständlich möglich, jeden dieser NC-Pins NC an seiner elektrischen Verbindung R1 mit einer Vorrichtung zu versehen, die der Unterbrechung der elektrischen Verbindung R1 zwischen dem jeweiligen NC-Pin NC und der integrierten Schaltung IS dient. In vorteilhafter Weiterbildung der Erfindung ist es gemäß Fig. 4 jedoch möglich, die obengenannte Vorrichtung nur an einem der betroffenen NC-Pins NC vorzusehen und bei den anderen elektrischen Verbindungen R1 jeweils nur einen Schalttransistor ST vorzusehen, deren Gates alle mit dem Ausgang Q der Kippschaltung KS der einen obengenannten Vorrichtung verbunden sind. Damit läßt sich Chipfläche sparen und es können im Bedarfsfall alle elektrischen Verbindungen R1 gleichzeitig unterbrochen werden. Es empfiehlt sich dabei vorteilhafterweise, die eine elektrische Verbindung R1, die mit dem Differenzverstärker D der Vorrichtung zur Unterbrechung verbunden ist, für einen etwas größeren maximalen Stromfluß zu dimensionieren als die restlichen elektrischen Verbindungen R1. Damit ist gewährleistet, daß im Bedarfsfall alle restlichen elektrischen Verbindungen R1 bereits unterbrochen sind, bis die eine elektrische Verbindung R1 unterbrochen wird.

Das Unterbrechen läßt sich erfindungsgemäß auf eine einfache Weise durchführen: Legt man an den "-"-Eingang des Differenzverstärkers D eine negativere Spannung an als an den "+"-Eingang des Differenzverstärkers D bzw. an den diesem zugeordneten NC-Pin NC, so schaltet bei entsprechender, dem Fachmann geläufiger Dimensionierung des Differenzverstärkers D dieser durch und nimmt einen logischen Pegel "1" an. Damit kippt die Kippschaltung KS; an ihrem Ausgang Q entsteht ein Potential, das den Steuertransistor ST durchschaltet. Die elektrische Verbindung R1 liegt jetzt einerseits über dem NC-Pin NC an einem relativ hohen Potential und andererseits auf dem - (niedrigen) zweiten Versorgungspotential VSS, das üblicherweise das Bezugspotential Masse ist. Damit wird der maximal zulässige Stromfluß innerhalb der elektrischen Verbindung R1 überschritten, sie zerstört sich selbst.

Da es möglich sein kann, daß sich beim Einschalten von Versorgungsspannungen bzw. bei deren Ansteigen während des Einschaltens und bei sonstigen elektrischen Signalen unbeabsichtigt dieser oben beschriebene Zustand einstellt (d.h. am "-"-Eingang des Differenzverstärkers D liegt kurzfristig eine negativere Spannung an als am "+"-Eingang), der zur Zerstörung der elektrischen Verbindungen R1 führt, ist es in vorteilhafter Weise möglich, an den Reset-Eingang R der Kippschaltung KS einen Impuls anzulegen, der während dieser kurzen Zeitspanne, in der das am "-"-Eingang des Differenzverstärkers D an liegende Spannungspotential, von einem Anfangswert ausgehend, auf seinen Endwert ansteigt, das Kippen der Kippschaltung KS unterdrückt. Dies ist in Fig. 5 dargestellt., Es ist vorteilhaft, daß dieser Impuls solange angelegt ist, bis das am "-"-Eingang des Differenzverstärkers D anliegende Spannungspotential mindestens 60% seines Endwertes erreicht hat. Bis zu diesem Zeitpunkt empfiehlt es sich, diesen Impuls gleich dem am "-"-Eingang anliegenden Spannungspotential zu machen. Anschließend läßt sich dieser Impuls wieder auf das zweite Versorgungspotential VSS absenken. Es ist weiterhin vorteilhaft, daß der Impuls mit dem Einschalten der beiden Versorgungspotentiale VCC und VSS angelegt wird.

Bezugszeichenliste NC NC-Pin

R1 elektrische Verbindung

IS integrierte Schaltung

D Differenzverstärker

KS Kippschaltung

ST Schalttransistor

VCC,VSS Versorgungspotential

R Rest-Eingang

Q Ausgang der Kippschaltung

RTIS restlicher Teil der integrierten Schaltung

**Ansprüche**

1. Integrierter Schaltkreis mit einer in ihm enthaltenen integrierten Schaltung und mit mindestens einem NC-Pin, wobei sich zunächst mindestens Teile der integrierten Schaltung in einer besonderen, nicht einem bestimmungsgemäßen Normalbetrieb entsprechenden Art betreiben lassen,

**dadurch gekennzeichnet,**

daß der NC-Pin (NC) zunächst eine elektrische Verbindung (R1) mit der integrierten Schaltung (IS) aufweist und daß die integrierte Schaltung (IS) eine Vorrichtung enthält, die einer Unterbrechung der elektrischen Verbindung (R1) zwischen dem NC-Pin (NC) und der integrierten Schaltung (IS) dient.

2. Integrierter Schaltkreis nach Anspruch 1,

**dadurch gekennzeichnet ,**

daß die elektrische Verbindung (R1) ein Widerstand ist.

3. Integrierter Schaltkreis nach Anspruch 1,

**dadurch gekennzeichnet,**

daß die elektrische Verbindung (R1) eine Leiterbahn ist.

4. Integrierter Schaltkreis nach einem der Ansprüche 1 bis 3,

**dadurch gekennzeichnet,**

daß die elektrische Verbindung (R1) im wesentlichen Polysilizium enthält.

5. Integrierter Schaltkreis nach einem der Ansprüche 1 bis 3,

**dadurch gekennzeichnet,**

daß die elektrische Verbindung (R1) im wesentlichen Metall, insbesondere Aluminium enthält.

6. Integrierter Schaltkreis nach einem der vorhergehenden Ansprüche,

**dadurch gekennzeichnet,**

daß die elektrische Verbindung (R1) bezüglich eines maximal möglichen Stromflusses dimensioniert ist.

7. Integrierter Schaltkreis nach einem der vorhergehenden Ansprüche,

**dadurch gekennzeichnet,**

daß die Vorrichtung einen Differenzverstärker (D), eine Kippschaltung (KS) und einen Schalttransistor (ST) aufweist.

8. Integrierter Schaltkreis nach Anspruch 7,

**dadurch gekennzeichnet,**

daß der Differenzverstärker (D) einen " + "-Eingang aufweist, der mit der elektrischen Verbindung (R1) verbunden ist, daß er einen "-"-Eingang aufweist, der mit einem Spannungspotential hoher Spannung, insbesondere mit einem ersten Versorgungspotential (VCC) der integrierten Schaltung (IS) verbunden ist, daß sein Ausgang mit einem ersten Eingang der Kippschaltung (KS) verbunden ist, daß die Kippschaltung (KS) als zweiten Eingang einen Reset-Eingang (R) aufweist, daß der Schalttransistor (ST) mit seiner Kanalstrecke zwischen die elektrische Verbindung (R1) und ein zweites Versorgungspotential (VSS) geschaltet ist und daß sein Gate mit einem Ausgang (Q) der Kippschaltung - (KS) verbunden ist.

9. Integrierter Schaltkreis nach einem der vorhergehenden Ansprüche,

**dadurch gekennzeichnet,**

daß der integrierte Schaltkreis bei Vorhandensein mehrerer NC-Pins (NC) mit jeweils einer elektrischen Verbindung (R1) zur integrierten Schaltung - (IS) nur eine ein zige Vorrichtung zur Unterbrechung der elektrischen Verbindungen (R1) aufweist, daß die Vorrichtung so viele Schalttransistoren - (ST) enthält, wie sie elektrische Verbindungen (R1) zu den NC-Pins (NC) aufweist, daß die Gates dieser Schalttransistoren (ST) gemeinsam angesteuert sind, daß die Kanalstrecken der Schalttransistoren - (ST) einerseits mit dem zweiten Versorgungspotential (VSS) und andererseits mit jeweils einer der obengenannten elektrischen Verbindungen (R1) verbunden sind, und daß der " + "-Eingang des Differenzverstärkers (D) nur mit einer einzigen der elektrischen Verbindungen (R1) verbunden ist.

10. Integrierter Schaltkreis nach Anspruch 9,

**dadurch gekennzeichnet,**

daß diejenige der elektrischen Verbindungen (R1), die mit dem " + "-Eingang des Differenzverstärkers (D) verbunden ist, bezüglich eines etwas höheren maximalen Stromflusses dimensioniert ist als die restlichen elektrischen Verbindungen (R1).

11. Verfahren zum Betreiben des integrierten Schaltkreises gemäß Anspruch 1,

**dadurch gekennzeichnet,**

daß das Unterbrechen der elektrischen Verbindung (R1) erfolgt, indem an den "-"-Eingang des Differenzverstärkers (D) ein niedrigeres Spannungspotential angelegt wird als an den NC-Pin (NC) und daß unbeabsichtigtes Unterbrechen der elektrischen Verbindung (R1) dadurch verhindert wird, daß bei einer Zunahme des Spannungspotentials am "-"-Eingang des Differenzverstärkers (D) von einem Anfangswert aus auf seinen Endwert während dieser Zunahme am Reset-Eingang (R) ein Impuls angelegt wird.

12. Verfahren nach Anspruch 11,

**dadurch gekennzeichnet,**

daß der Impuls solange angelegt wird, bis das am "-"-Eingang des Differenzverstärkers (D) anleigende Spannungspotential mindestens 60% seines vorgesehenen Endwertes erreicht hat.

13. Verfahren nach Anspruch 11 oder 12,

**dadurch gekennzeichnet,**

daß der Impuls in Verbindung mit dem Einschalten einer Spannungsversorgung für die beiden Versorgungspotentiale (VCC,VSS) angelegt wird.

## FIG 1

NC    IS    NC    NC

## FIG 2

NC

R1

D

+

VCC

KS

q̄

R

Q

ST

VSS

IS    RTIS

## FIG 3

NC

R1

D

+

VCC

KS

R

Q

ST

VSS

IS    RTIS

## FIG 4

## FIG 5

Europäisches
Patentamt

**EUROPÄISCHER RECHERCHENBERICHT**

Nummer der Anmeldung

EP 86 11 1517

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENTS ABSTRACTS OF JAPAN, Band 5, Nr. 149 (E-75)[821], 19. September 1981; & JP-A-56 81 962 (FUJITSU K.K.) 04-07-1981 | 1 | H 01 L 23/50<br>H 01 L 23/52<br>G 06 F 11/20 |
| | --- | | |
| A | IBM TECHNICAL DISCLOSURE BULLETIN, Band 10, Nr. 2, Juli 1967, Seiten 170-171, New York, US; G.V. DRAKE et al.: "Fused diode matrix fabrication" | 1,3 | |
| | --- | | |
| A | EP-A-0 078 165 (TOSHIBA)<br>* Ansprüche 1,3-5,7 * | 1-6 | |
| | ----- | | |

RECHERCHIERTE
SACHGEBIETE (Int. Cl.4)

H 01 L

Der vorliegende Recherchenbericht wurde für alle Patentansprüche erstellt.

| Recherchenort | Abschlußdatum der Recherche | Prüfer |
|---|---|---|
| DEN HAAG | 05-12-1986 | DE RAEVE R.A.L. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82